# EUROPEAN PATENT APPLICATION

(11) **EP 2 916 626 A1**
(43) Date of publication of application: **09.09.2015**
(21) Application number: 13851712.3
(22) Date of filing: 01.10.2013
(51) Int. Cl.: H05K 1/18, H05K 1/14, H05K 7/20

(54) **MODULE**

(30) Priority: 01.11.2012 JP 2012241896
(71) Applicant: KABUSHIKI KAISHA TOYOTA JIDOSHOKKI, Kariya-shi, Aichi 448-8671 (JP)
(72) Inventor: OZAKI, Kiminori, Kariya-shi Aichi 448-8671 (JP); KOIKE, Yasuhiro, Kariya-shi Aichi 448-8671 (JP); ASANO, Hiroaki, Kariya-shi Aichi 448-8671 (JP); SHIMADU, Hitoshi, Kariya-shi Aichi 448-8671 (JP); KAWAGUCHI, Shigeki, Tokai-shi Aichi 476-0002 (JP); ASAI, Tomoaki, Nagoya-shi Aichi 456-0076 (JP)
(74) Representative: TBK
(86) International application number: PCT/JP2013/076659
(87) International publication number: WO 2014/069143

(57) **Abstract**

This module includes an insulating substrate having a first surface and a second surface, which are positioned on opposite sides to each other, a first metal layer that is provided on the first surface of the insulating substrate and include a metal plate, a second metal layer provided on the second surface of the insulating substrate, a first circuit board including the insulating substrate, the first metal layer, and the second metal layer, an electronic component joined to the first metal layer, and a positioning portion, which is located on the joint surface between the first metal layer and the electronic component, at which the first metal layer and the electronic component are engaged with each other through a recess-projection relationship. The insulating substrate is located between the second metal layer and a part of the first metal layer where the positioning portion is located.

## Description

### TECHNICAL FIELD

The present invention relates to a module having a circuit board, which includes an insulating substrate, a first metal layer provided on a first surface of the insulating substrate, and a second metal layer provided on a second surface of the insulating substrate, and an electronic component joined to the first metal layer.

### BACKGROUND ART

When joining electronic components such as connectors to a circuit board, the positions of the components relative to each other need to be accurately determined to increase the attachment accuracy. Patent Document 1 discloses a technique for positioning an electronic component on a circuit board, in which projections are located on an electronic component and through holes are located in the circuit board. The projections and the through holes are engaged with each other to determine the positions of the electronic components.

### PRIOR ART DOCUMENT

### Patent Document

Patent Document 1: Japanese Laid-Open Patent Publication No. 9-55245

### SUMMARY OF THE INVENTION

### Problems that the Invention is to Solve

Circuit boards, to which electronic components are joined, include double sided circuit boards, which have a metal layer on either side of an insulating substrate. If through holes for positioning are located in a double sided circuit board as disclosed in Patent Document 1, no insulating substrate exists between the metal layers in the through holes, which reduces the electrical distance between the metal layers. Sufficient insulation between the metal layers of the double sided circuit board thus cannot be achieved.

Accordingly, it is an objective of the present invention to provide a module that facilitates positioning of electronic components with respect to a circuit board, while ensuring sufficient insulation between metal layers.

### Means for Solving the Problems

To achieve the foregoing objective and in accordance with one aspect of the present invention, a module is provided that includes an insulating substrate having a first surface and second surface, which are located on opposite sides, a first metal layer including by a metal plate provided on the first surface of the insulating substrate, a second metal layer provided on the second surface of the insulating substrate, a first circuit board that includes the insulating substrate, the first metal layer, and the second metal layer, an electronic component joined to the first metal layer, and a positioning portion provided on a joint surface between the first metal layer and the electronic component. At the positioning portion, the first metal layer and the electronic component are engaged with each other through a recess-projection relationship. The insulating substrate is located between the second metal layer and a portion of the first metal layer at which the positioning portion is provided.

### BRIEF DESCRIPTION OF THE DRAWINGS

Fig. 1A is a cross-sectional view illustrating a module according to one embodiment;
Fig. 1B is an enlarged view of the positioning portion shown in Fig. 1 A;
Fig. 2 is a top view of the first substrate shown in Fig. 1 A;
Fig. 3 is a top view of a first circuit board of a modification;
Fig. 4 is a cross-sectional view taken along line 4-4 in Fig. 3;
Fig. 5A is a cross-sectional view showing a module according to another modification;
Fig. 5B is an enlarged view of the positioning portion shown in Fig. 5A;
Fig. 6A is a cross-sectional view showing a module according to another modification; and
Fig. 6B is an enlarged view of the positioning portion shown in Fig. 6A.

### MODES FOR CARRYING OUT THE INVENTION

One embodiment will now be described with reference to the drawings.

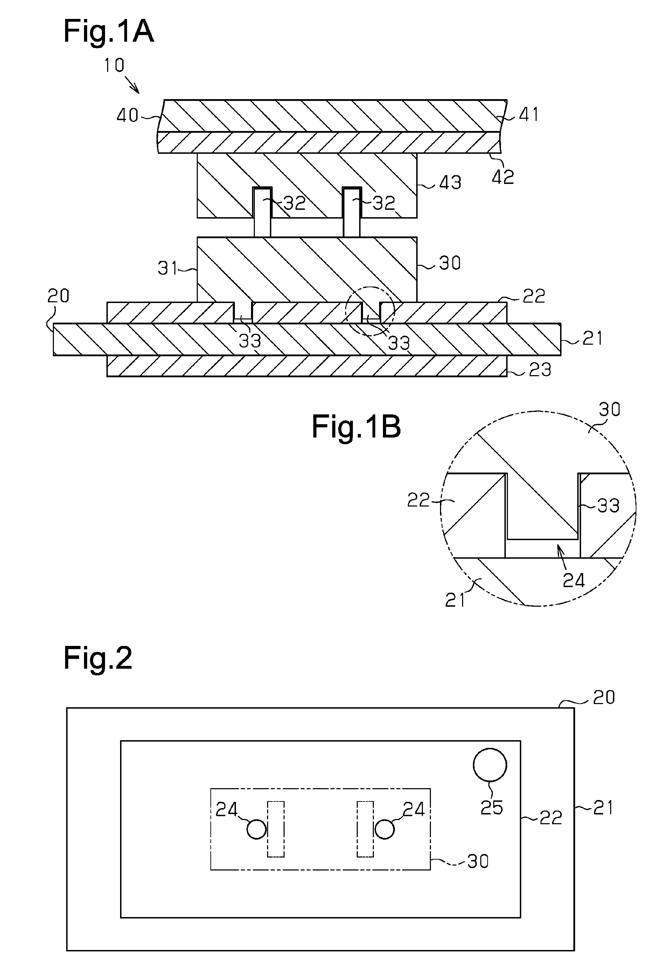

As shown in Fig. 1, a module 10 according to the present embodiment includes a first circuit board 20 and a second circuit board 40, which are electrically connected to each other. For example, the first circuit board 20 is a power supply board, and the second circuit board 40 is a control board.

The first circuit board 20 is a double sided circuit board and includes an insulating substrate 21 having an upper surface (first surface) and a lower surface (second surface) located on opposite sides, a first metal layer 22 bonded to the upper surface of the insulating substrate 21, and a second metal layer 23 bonded to the lower surface of the insulating substrate 21. The first metal layer 22 and the second metal layer 23 each include a metal plate patterned into a predetermined shape.

The metal plates of the first metal layer 22 and the second metal layer 23 may be made of electrically conductive metal such as copper and aluminum. In a case where aluminum is used, parts to be soldered are plated. The thickness of the metal plates is preferably from 0.4 to 2.0 mm, and more preferably from 0.5 to 1.0 mm. The first metal layer 22 and the second metal layer 23 are obtained through stamping, that is, by stamping metal plates into predetermined patterns. As shown in Fig. 2, a coordinate reference hole 25 for checking coordinates extends through the first metal layer 22.

As shown in Fig. 1, an electronic component, which is a male connector 30, is joined to the upper surface of the first metal layer 22 of the first circuit board 20 via an adhesive such as solder. The male connector 30 includes a main body 31 covered with a plastic case and a pair of terminal portions 32, which extends upward from the main body 31. The lower surface of the main body 31 is joined to the upper surface of the first metal layer 22. Therefore, the upper surface of the first metal layer 22 of the first circuit board 20 and the lower surface of the main body 31 of the male connector 30 correspond to joint surfaces.

The second circuit board 40 is a single layer circuit board that includes an insulating substrate 41 and a third metal layer 42, which is bonded to the lower surface of the insulating substrate 41 and is patterned into a predetermined shape. A female connector 43, which corresponds to the male connector 30, is joined to the lower surface of the third metal layer 42 of the second circuit board 40. When the male connector 30 and the female connector 43 are connected to each other, the first circuit board 20 and the second circuit board 40 are electrically connected to each other.

The structure of the joint portion between the first circuit board 20 and the male connector 30 will now be described. As shown in Figs. 1B and 2, two recesses 24, which have a circular cross-sectional shape, are provided in the upper surface of the first metal layer 22 of the first circuit board 20. The recesses 24 open toward the male connector 30. The recesses 24 through holes with a circular cross-sectional shape in the first metal layer 22. Each recess 24 has a cylindrical (groove-like) shape with the inner circumferential surface of the through holes serving as an inner wall and the upper surface of the insulating substrate 21 serving as a bottom wall. The depth of the recesses 24 is thus equal to the thickness of the first metal layer 22.

Two projections 33 are located on the lower surface of the main body 31 of the male connector 30. The projections 33 are located at positions facing the recesses 24. Each projection 33 is columnar and has a diameter that is slightly smaller than the diameter of the recesses 24. The height of the projections 33 is smaller than the depth of the recesses 24. The projections 33 are each inserted into and engaged with the corresponding recess 24 through a recess-projection relationship.

A terminal, which is a lead (not shown), is provided on the lower surface of the male connector 30 separately from the projections 33. The lead and the first metal layer 22 are connected to each other so that the first circuit board 20 and the male connector 30 are electrically connected to each other.

Next, a method for joining the first circuit board 20 and the male connector 30 with each other and operation of the module 10 of the present embodiment will be described.

When the male connector 30 is joined to the upper surface of the first metal layer 22 of the first circuit board 20, an adhesive such as solder is applied to a part of the upper surface of the first metal layer 22 to which the male connector 30 is to be joined. With reference to the coordinate reference hole 25, which is located in the first metal layer 22, the male connector 30 is moved to a position of target coordinates, where the male connector 30 should be located on the first metal layer 22, by a surface-mount device, and the male connector 30 is placed on the first metal layer 22 with the adhesive in between.

At this time, the projections 33, which are located on the main body 31 of the male connector 30, are inserted into the recesses 24, which are located in the first circuit board 20, so that the recesses 24 and the projections 33 are engaged with each other through a recess-projection relationship. This determines the position of the male connector 30 with respect to the first circuit board 20. When the solder is set, the male connector 30 is joined to the first circuit board 20.

As shown in Fig. 1, in the first circuit board 20 of the module 10 of the present embodiment, the insulating substrate 21 is located between the first metal layer 22 and the second metal layer 23 at the positions at which the recesses 24, which serve as positioning portions, are arranged. Thus, even though positioning portions are provided, the electrical distance between the first metal layer 22 and the second metal layer 23 is not reduced. That is, insulation between the first metal layer 22 and the second metal layer 23 is ensured.

In the present embodiment, the first metal layer 22 is a metal plate having a predetermined thickness. This allows the recesses 24, which are engaged with the projections 33, to be provided on the first circuit board 20 without providing through holes in the insulating substrate 21 as in the conventional configuration.

The present embodiment provides the following advantages.

(1) The module 10 includes the first circuit board 20 and the male connector 30. The first circuit board 20 has the insulating substrate 21, the first metal layer 22, which is made of a metal plate on the upper surface of the insulating substrate 21, and the second metal layer 23, which is located on the lower surface of the insulating substrate 21. The male connector 30 is electrically connected to the first metal layer 22. The recesses 24 and the projections 33, which are engaged with each other through a recess-projection relationship, are provided on the joint surfaces of the first metal layer 22 and the male connector 30, respectively. The insulating substrate 21 is located between the positions of the first metal layer 22 at which the recesses 24 are provided and the second metal layer 23.
   With this configuration, the recesses 24 of the first circuit board 20 and the projections 33 of the male connector 30 are engaged with each other, so that the position of the male connector 30 is easily determined with respect to the first circuit board 20. This reduces the attachment tolerance of the male connector 30 with respect to the first circuit board 20.
   In the first circuit board 20, the insulating substrate 21 is located between the parts where the recesses 24 of the first metal layer 22 are located and the second metal layer 23, so that the electrical distance between the first metal layer 22 and the second metal layer 23 is not reduced. This ensures the insulation between the first metal layer 22 and the second metal layer 23 in the first circuit board 20.
(2) Each recesses 24 extends through the first metal layer 22 and has a cylindrical shape (groove-like shapes) with the upper surface (front surface) of the insulating substrate 21 serving as the bottom wall. That is, the recesses 24 are provided in the first circuit board 20 through holes in the first metal layer 22. With this configuration, when the first metal layer 22 is provided through stamping, the through holes providing the recesses 24 can be formed simultaneously, which facilitates formation of the recesses 24. Also, when the first metal layer 22 is bonded to the upper surface of the insulating substrate 21, the through holes serve as gas vent holes for venting gas from the space between the insulating substrate 21 and the first metal layer 22.
(3) The height of the projections 33 is smaller than the depth of the recesses 24. With this configuration, when positioning is performed by engaging the recesses 24 and the projections 33 with each other, the distal ends of the projections 33 do not contact the bottom surfaces of the recesses 24. This restrains the male connector 30 from being inclined relative to the first circuit board 20. Also, the male connector 30 is restrained from being separated from the first circuit board 20 by an unnecessarily wide space.
(4) The positioning portions (the recesses 24 and the projections 33) are provided at the joint surfaces of the first circuit board 20 and the male connector 30 for connecting the first circuit board 20 and the second circuit board 40 to each other. Generally, among electronic components joined to a circuit board, a connector requires a high attachment accuracy with respect to the circuit board since the connector is joined to two or more circuit boards. Therefore, providing positioning portions in joint surfaces of a connector and a circuit board is particularly effective to obtain a highly reliable module that is installed with a high accuracy.
(5) Two sets of the recesses 24 and the projections 33 are provided to perform positioning at two points on the joint surfaces. This configuration restricts the male connector 30 from rotating relative to the first circuit board 20.

The above described embodiment may be modified as follows.

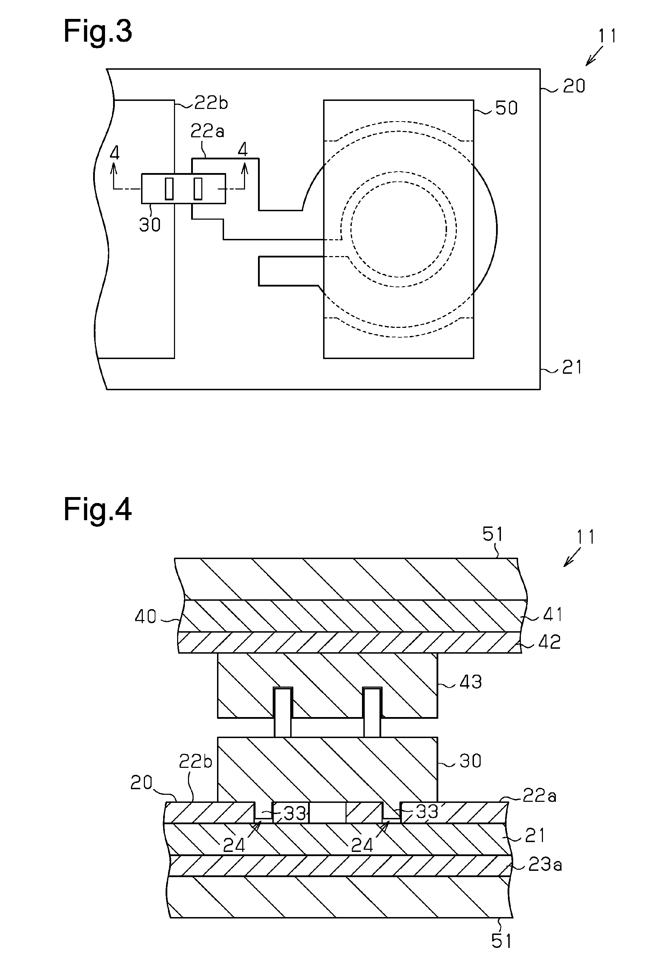

The module 10 of the above illustrated embodiment is not limited to any specific structure. For example, the present invention may be applied to a module 11 illustrated in Figs. 3 and 4, which is a transformer of a DC-DC converter. The module 11 shown in Figs. 3 and 4 includes a first circuit board 20 and a second circuit board 40, which are electrically connected to each other. In Fig. 3, the second circuit board 40 is omitted for purposes of illustration.

The first circuit board 20 is a double sided circuit board and includes an insulating substrate 21, a first coil portion 22a, a wiring portion 22b, and a second coil portion 23a. The first coil portion 22a and the wiring portion 22b provide a first metal layer bonded to the upper surface of the insulating substrate 21. The second coil portion 23a provides a second metal layer bonded to the lower surface of the insulating substrate 21. The first coil portion 22a and the second coil portion 23a are each a metal plate that is patterned to have a coil-like shape with a predetermined number of turns. The wiring portion 22b includes a metal plate that is patterned into a predetermined shape. A magnetic core 50, which provides a closed magnetic circuit, is attached to the first circuit board 20 to correspond to the centers of and parts adjacent to the first coil portion 22a and the second coil portion 23a.

A male connector 30 for input is joined via an adhesive such as solder to the upper surface of the first coil portion 22a and the wiring portion 22b, which provides the first metal layer. The male connector 30 bridges the first coil portion 22a and the wiring portion 22b. A recess 24, which opens toward the male connector 30, is provided in the upper surface of each of the first coil portion 22a and the wiring portion 22b of the first circuit board 20. The projections 33 on the male connector 30 are inserted into the recesses 24 so that the projections 33 and the recesses 24 are engaged with each other through a recess-projection relationship.

The second circuit board 40 is a control board for controlling the first circuit board 20 and has the same configuration as that of the second circuit board 40 of the above illustrated embodiment. When the male connector 30 of the first circuit board 20 and the female connector 43 of the second circuit board 40 are connected to each other, the first circuit board 20 and the second circuit board 40 are electrically connected to each other. As shown in Fig. 4, the first circuit board 20 and the second circuit board 40 are each fixed to a heat dissipation member 51. The heat dissipation members 51 dissipate the heat generated by heat generating members such as semiconductor devices mounted on the first circuit board 20 and the second circuit board 40, thereby cooling the module 11.

The numbers of the recesses 24 and the projections 33, which serve as positioning portions, are not particularly limited. That is, only a set of a recess 24 and a projection 33 may be provided. Alternatively, three or more sets of recesses 24 and projections 33 may be provided.

The cross-sectional shape of the recesses 24 and the projections 33, which serve as positioning portions, is not particularly limited. For example, the cross-sectional shape of the recesses 24 and the projections 33 may be oval or polygonal. If the cross-sectional shape is other than a circular shape, a single set of a recess 24 and a projection 33, which serve as positioning members, is capable of restricting the male connector 30 from rotating relative to the first circuit board 20.

The recesses 24 may be provided in the first metal layer 22 without through holes. In this case, the recesses 24 each have a cylindrical shape (groove-like shape) with an inner wall and a bottom wall that include parts of the first metal layer 22.

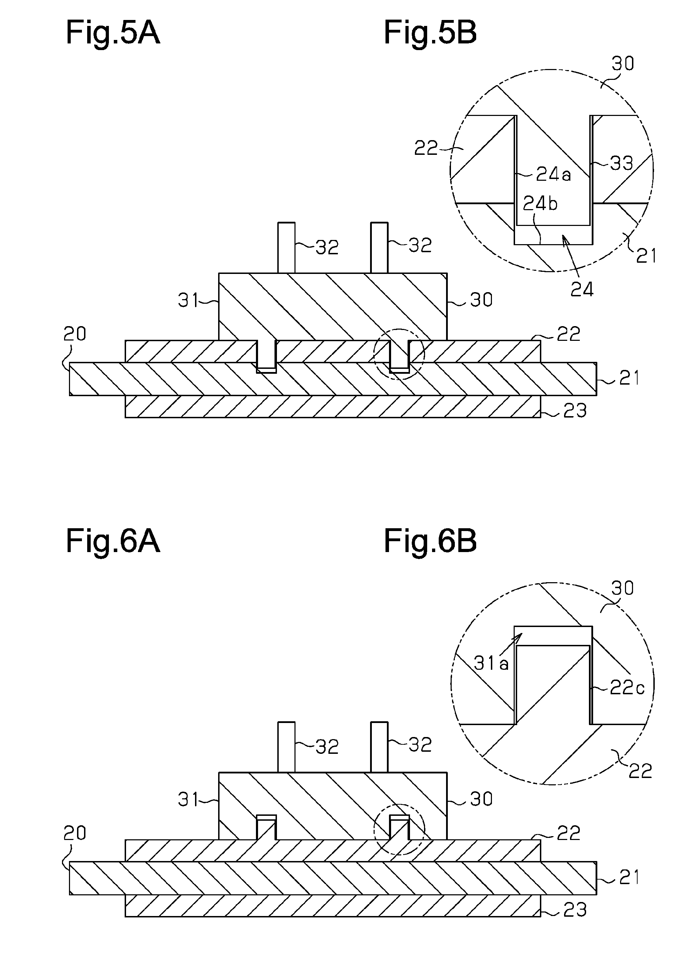

As shown in Figs. 5A and 5B, each recess 24 may include a through hole 24a in the first metal layer 22 and a recess 24b, which is located in the upper surface of the insulating substrate 21 and opens toward the through hole 24a. This increases the depth of the recesses 24, so that the height of the projections 33 can be easily set to a value less than the depth of the recesses 24.

The height of the projections 33 may be greater than or equal to the depth of the recesses 24.

As shown in Figs. 6A and 6B, the projection-recess relationship of the positioning portion may be reversed. That is, projections 22c may be located on the first metal layer 22, and recesses 31 a may be located in the main body 31 of the male connector 30.

The male connector 30 may be replaced by a known electronic component (for example, a semiconductor device) fixed to a circuit board.

When joining the male connector 30 to the first metal layer 22, the recesses 24 may be used, in place of or in addition to the coordinate reference hole 25, as coordinate reference holes to move the male connector 30 to a position of target coordinates.

The projections 33 do not need be located at symmetrical positions with respect to the center of the main body 31, but may be located at asymmetrical positions with respect to the center of the main body 31. This structure prevents the connector from being connected with the reverse polarities.

## Claims

1. A module comprising:
an insulating substrate having a first surface and second surface, which are located on opposite sides;
a first metal layer including by a metal plate provided on the first surface of the insulating substrate;
a second metal layer provided on the second surface of the insulating substrate;
a first circuit board that includes the insulating substrate, the first metal layer, and the second metal layer;
an electronic component joined to the first metal layer; and
a positioning portion provided on a joint surface between the first metal layer and the electronic component, wherein, at the positioning portion, the first metal layer and the electronic component are engaged with each other through a recess-projection relationship,
wherein the insulating substrate is located between the second metal layer and a portion of the first metal layer at which the positioning portion is provided.

2. The module according to claim 1, wherein
the positioning portion includes a projection on the electronic component and a recess in the first circuit board, the projection being configured to be inserted into the recess, and
the first metal layer and the electronic component are joined to each other with the projection inserted into the recess.

3. The module according to claim 2, wherein the recess has a cylindrical shape that extends through the first metal layer and has a bottom surface that is a surface of the insulating substrate.

4. The module according to claim 2 or 3, wherein the projection has a height and the recess has a depth, and the height of the projection is less than the depth of the recess.

5. The module according to any one of claims 1 to 4, further comprising a second circuit board,
wherein the electronic component is a connector for electrically connecting the first circuit board and the second circuit board to each other.

6. The module according to claim 5, wherein the first circuit board and the second circuit board are each fixed to a heat dissipation member.

7. The module according to claim 5 or 6, wherein
the first circuit board is a power supply board, and
the second circuit board is a control board.

8. The module according to any one of claims 1 to 7, wherein
the first metal layer is a primary coil of a transformer, and
the second metal layer is a secondary coil of the transformer.
